# Europäisches Patentamt
## European Patent Office
## Office européen des brevets

(19)

(11) Veröffentlichungsnummer: **0 025 234**
**B1**

(12) **EUROPÄISCHE PATENTSCHRIFT**

(45) Veröffentlichungstag der Patentschrift:
23.01.85

(51) Int. Cl.⁴: **H 03 F 3/217**

(21) Anmeldenummer: **80200581.9**

(22) Anmeldetag: **19.06.80**

(54) **Niederfrequenz-Leistungsverstärker und dessen Verwendung in einem amplitudenmodulierten Sender.**

(30) Priorität: **09.08.79 CH 7307/79**

(43) Veröffentlichungstag der Anmeldung:
**18.03.81 Patentblatt 81/11**

(45) Bekanntmachung des Hinweises auf die Patenterteilung:
**23.01.85 Patentblatt 85/4**

(84) Benannte Vertragsstaaten:
**CH DE FR GB LI**

(56) Entgegenhaltungen:
**FR - A - 2 377 116**
**FR - A - 2 404 337**
**GB - A - 1 248 209**
**US - A - 3 253 228**
**US - A - 3 579 132**

**INSTRUMENTS AND EXPERIMENTAL TECHNIQUES,
Band 15, Nr. 3, 1972, New York, US, P.E. MOLOTOV et
al.: "Generator producing a voltage having an arbitrary
waveshape using a pulsewidth modulator"**
**CONTROL ENGINEERING, Band 17, Nr. 7, Juli 1970,
New York, US, J.A. ROSS: "A high-power switching
amplifier"**

(73) Patentinhaber: **PATELHOLD Patentverwertungs- &
Elektro-Holding AG, Glarus (CH)**

(72) Erfinder: **Kyrian, Bohumil, Dipl.-Ing., Dammstrasse 36,
CH-5200 Windisch (CH)**
Erfinder: **Milavec, Johann, Dipl.-Ing., Wiesenweg 5,
CH-5200 Windisch (CH)**
Erfinder: **Tschol, Wilhelm, Hagenbüchlerstrasse 1,
CH-5442 Fislisbach (CH)**

## Beschreibung

Die vorliegende Erfindung betrifft einen Niederfrequenz (NF)-Leistungsverstärker gemäß dem Oberbegriff des Anspruchs 1 sowie dessen Verwendung in einem amplitudenmodulierten Sender.

Die bisher gebräuchlichen NF-Leistungsverstärker für hohe Ausgangsleistungen sind praktisch alle nach der gleichen Grundschaltung aufgebaut. Sie enthalten einen Gegentakt-B-Verstärker mit mindestens zwei Verstärkerröhren und einem Ausgangstransformator. Das zu verstärkende NF-Signal wird an die Gitter der beiden Röhren geleitet, deren Anoden mit den Klemmen der Primärwicklung des Ausgangstransformators verbunden sind. Die eine Klemme der Sekundärwicklung des Ausgangstransformators ist über einen Kondensator mit der Masse und die andere Klemme ist mit der Last verbunden. Die Speisespannung für die beiden NF-Verstärkerröhren wird über einen Mittelabgriff der Primärwicklung des Ausgangstransformators zugeführt.

NF-Leistungsverstärker der beschriebenen Art können an sehr unterschiedliche Verwendungen angepaßt und für entsprechend unterschiedliche Leistungen dimensioniert werden, beispielsweise zum Erregen von Großlautsprechern, in Vorrichtungen zum induktiven Erwärmen, in Regelverstärkern und als Modulationsverstärker für Rundfunksender. Alle Ausführungsformen weisen für große Leistungen einige grundsätzliche Nachteile auf. Für den Gegentakt-B-Verstärker sind Hochleistungsröhren erforderlich, die teuer sind und eine vergleichsweise kurze Betriebsdauer aufweisen. Diese Röhren müssen bei Verstärkern mit hoher Ausgangsleistung mit Hochspannung betrieben werden, was den gesamten Schaltungsaufwand erhöht. Der Ausgangstransformator ist ein großes und schweres Bauelement, dessen Gewicht z. B. bei einem Modulationsverstärker für einen 300-kW-Sender etwa sechs Tonnen betragen kann. Schließlich ist der Wirkungsgrad eines mit sinusförmigen Signalen ausgesteuerten Gegentakt-B-Verstärkers und der nachgeschalteten Last von der Aussteuerung abhängig; er erreicht gesamthaft bestenfalls 70%.

Das seit langem bekannte Prinzip der Pulsdauermodulation bietet zwar einerseits Vorteile hinsichtlich Wirkungsgrad, ist aber andererseits mit schaltungstechnischen Schwierigkeiten verbunden.

Eine bekannte Lösung (DE-C-1 218 557 vom 8. 2. 63) ist dadurch gekennzeichnet, daß eine auf hohem Potential zwischen Hochspannungsgleichrichter und Last liegende Schaltröhre am Steuergitter mit impulsbreitenmodulierten Signalen in geeigneter Weise angesteuert wird.

Eine weitere Lösung ist für Rundfunksender bekannt (siehe Publikation in der Fachzeitschrift Funktechnik 32. Jahrgang Nr. 13/1977), bei der schaltungstechnisch die HF-Endstufenröhre in Serie mit der impulsbreitenmoduliert angesteuerten Schaltröhre liegt, wobei die Kathode der HF-Endstufenröhre hochfrequenzmäßig an Masse liegt, aber im Rhythmus der Modulationsfrequenz schwingt.

Weiterhin ist aus der Druckschrift FR-PS 2 404 337 ein Modulationsverstärker mit Pulsdauermodulation bekannt, bei dem ausgangsseitig mehrere Schaltstufen parallel betrieben und die Ströme der einzelnen Schaltstufen zu einem hohen Ausgangsstrom bei vergleichsweise kleiner Ausgangsspannung kombiniert werden.

Alle erwähnten Lösungen bedingen einen hohen Schaltungsaufwand und erfordern zudem eine hohe Versorgungsspannung für die Senderendstufe.

Der vorliegenden Erfindung liegt die Aufgabe zugrunde, einen einfachen und wenig aufwendigen NF-Leistungsverstärker zu schaffen, der einerseits die eingangs erwähnten Nachteile hinsichtlich Wirkungsgrad und Kosten vermeidet und der andererseits die Schwierigkeiten der als Beispiel genannten beiden Verfahren einer Pulsdauer-Modulation bezüglich schaltungstechnischem Aufwand eliminiert; einen NF-Leistungsverstärker, der mit einer mittleren Spannung betrieben werden kann und gesamthaft einen hohen und vom Modulationsgrad unabhängigen Wirkungsgrad aufweist und der zudem mit Leistungshalbleiter statt mit Röhren verwirklicht werden kann.

Erfindungsgemäß wird diese Aufgabe mit einem NF-Leistungsverstärker der eingangs erwähnten Art gelöst, der die Merkmale aus dem Kennzeichen des Anspruchs 1 aufweist.

Die Umwandlung des NF-Signals in Impulse ermöglicht, anstelle der Verstärkerröhren geeignete elektronische Schalter mit sehr kurzer Schaltzeit zu verwenden, die bei gleicher Ausgangsleistung den Wirkungsgrad des Verstärkers verbessern. Weiter ermöglicht die Kaskadenschaltung der Schaltelement-Ausgänge, den Leistungsverstärker mit einer niedrigen Speisespannung zu betreiben, was den Aufbau ganz wesentlich vereinfacht und verbilligt. Schließlich kann durch die Verwendung einer Mehrzahl gruppenweise parallel oder in Reihe geschalteter Schaltstufen eine nützliche Redundanz des gesamten NF-Leistungsverstärkers erreicht werden, so daß dessen Funktionsfähigkeit beim Ausfall einer der Stufen nicht merklich beeinträchtigt wird.

Im folgenden wird die Erfindung mit Hilfe der Figuren an einem Ausführungsbeispiel beschrieben. Es zeigt

Fig. 1 das Prinzipschema einer bevorzugten Ausführungsform des neuen NF-Leistungsverstärkers,

Fig. 2 das Blockschema eines für den NF-Leistungsverstärker gemäß Fig. 1 geeigneten Impulsmodulators,

Fig. 3 das Blockschema einer für den NF-Leistungsverstärker gemäß Fig. 1 geeigneten Schaltstufe,

Fig. 4 die schematische Darstellung eines integrierten Tiefpaßfilters,

Fig. 5 die schematische Darstellung der Aussteuerung einer Ausgangsimpulsfolge durch die Überlagerung zweier gegeneinander phasenverschobenen Eingangsimpulsfolgen und

Fig. 6 die schematische Darstellung der Frequenzerhöhung einer Ausgangsimpulsfolge durch die Überlagerung mehrerer phasenverschobener Eingangsimpulsfolgepaare.

In den Figuren sind einander entsprechende Bauelemente mit dem gleichen Bezugszeichen versehen.

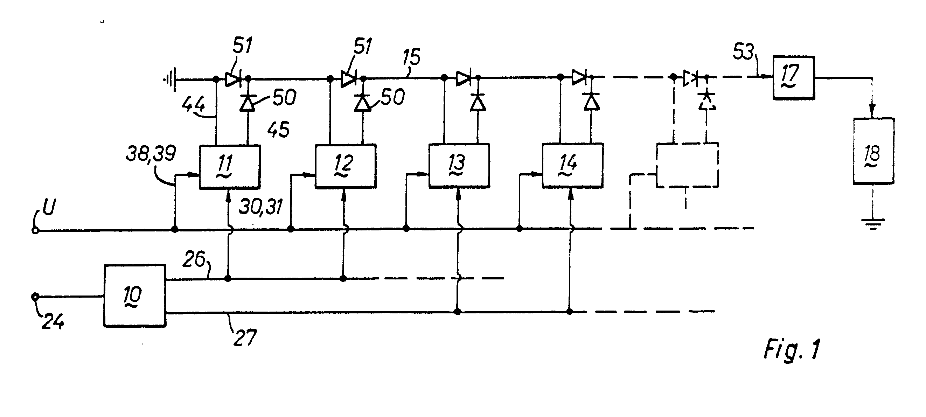

Die in Fig. 1 gezeigte Ausführungsform eines NF-Leistungsverstärkers ist zur Speisung eines amplitudenmodulierten Rundfunksenders vorgesehen. An diese Art Leistungsverstärker werden bezüglich Frequenzgang und Verstärkung besonders hohe Anforderungen gestellt, weshalb sie zur Beschreibung des Aufbaus und der Arbeitsweise des neuen Verstärkers besonders gut geeignet ist.

Der NF-Leistungsverstärker enthält einen Impulsmodulator 10, mehrere Gruppen parallel geschalteter Schaltstufen 11, 12 bzw. 13, 14 und die Verbindungsleitung 15, die die Ausgänge aller Schaltstufen mit dem Eingang eines Tiefpaßfilters 17 verbindet, dessen Ausgang mit einer Last 18 verbunden ist. Im gezeigten Beispiel ist angenommen, daß die Last die HF-Endstufe eines amplitudenmodulierten Senders ist.

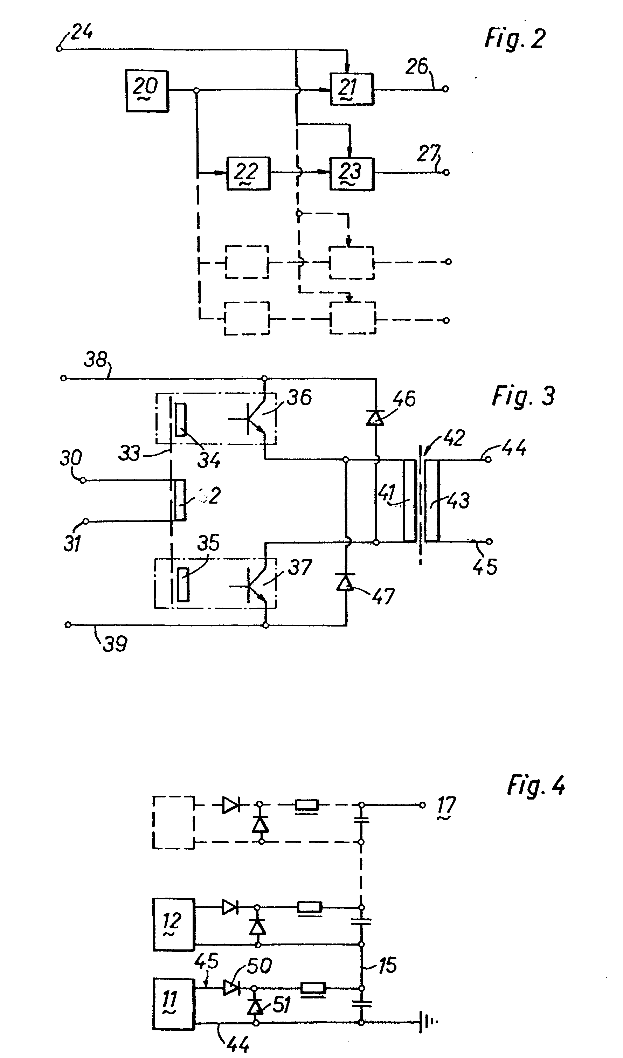

Fig. 2 zeigt das Blockschema eines geeigneten Impulsmodulators. Dieser enthält einen Impulsgenerator 20, dessen Ausgang mit einem Eingang eines Modulators 21 und dem Eingang mindestens eines Phasenschiebers 22 verbunden ist. Der Ausgang dieses Phasenschiebers ist an einen Eingang eines weiteren Modulators 23 geführt. Der andere Eingang dieses Modulators ist mit der Eingangsklemme 24 für das NF-Signal verbunden. An den Ausgang jedes Modulators ist eine Signalleitung 26, 27 angeschlossen.

Wie im folgenden noch beschrieben werden wird, kann es vorteilhaft sein, einen Impulsmodulator zu verwenden, der mehr als zwei Ausgangssignale liefert. Dann werden weitere Phasenschieber mit nachgeschaltetem Modulator an den Impulsgeber angeschlossen, was in Fig. 2 mit gestrichelten Linien angedeutet ist.

Fig. 3 zeigt das Blockschema einer für den neuen NF-Leistungsverstärker geeigneten Schaltstufe. Diese Stufe enthält einen Signaleingang 30, 31, an den eine der Signalleitungen 26 oder 27 vom Impulsmodulator 10 geführt ist und mit der Primärwicklung 32 einer Steuereinheit 33 verbunden ist. Die Sekundärwicklungen 34, 35 dieser Steuereinheit sind mit der Steuerelektrode mindestens eines zugeordneten Schaltelementes 36 bzw. 37 und die Elektroden der Schaltelemente 36 und 37 mit der positiven und negativen Schiene 38, 39 der Speisespannungsquelle bzw. mit der Primärwicklung 41 eines Leistungsübertragers 42 verbunden. Die Sekundärwicklung 43 dieses Leistungsübertragers ist mit den Ausgangsleitungen 44, 45 verbunden.

Die Schaltstufe enthält weiter zwei Dioden 46, 47, die zwischen dem »negativen« Anschluß der Primärwicklung des Leistungsübertragers und der Schiene 38 für die positive bzw. dem »positiven« Anschluß und der Schiene 39 für die negative Speisespannung angeschlossen sind und beim Unterbrechen des Stroms die Schaltelemente gegen Überspannung schützen.

Bei einer bevorzugten Ausführungsform der Schaltstufe sind zwei Steuereinheiten 33 vorgesehen, von denen die eine den Einschaltimpuls für die Schaltelemente und die andere den Ausschaltimpuls überträgt. Weiter können anstelle der zwei gezeigten Schaltelemente 36, 37 zwei Gruppen parallel geschalteter Schaltelemente verwendet werden, was ermöglicht, den Strom durch die Primärwicklung des Leistungsübertragers 42 entsprechend zu erhöhen. Als Schaltelemente werden vorzugsweise geeignete Leistungshalbleiter, Elektronenröhren oder eine geeignete Kombination derselben verwendet.

Die eine Ausgangsleitung 44 jeder Schaltstufe (Fig. 1) ist direkt, die andere Ausgangsleitung 45 über einen Gleichrichter 50 mit der Verbindungsleitung 15 verbunden. Außerdem enthält die Verbindungsleitung zwischen den Anschlüssen jedes Ausgangsleitungspaars einen weiteren Gleichrichter 51. Über die Gleichrichter 50, 51 werden die Leistungsimpulse der verschiedenen Ausgänge 44, 45 längs der Verbindungsleitung 15 summiert und an den Eingang 53 des Tiefpaßfilters 17 weitergeleitet.

Die schaltungsmäßige Anordnung des Tiefpaßfilters braucht nicht notwendigerweise nach Fig. 1 ausgeführt zu werden. Andere Lösungen bestehen darin, das Tiefpaßfilter ganz oder teilweise in die Ausgänge 44, 45 der Schaltstufen 11, 12 ... bzw. in die Verbindungsleitung zu integrieren. Eine mögliche Lösung ist in Fig. 4 dargestellt.

Beim Betrieb des beschriebenen NF-Leistungsverstärkers wird das zugeführte NF-Signal in mindestens zwei Impulsfolgen umgewandelt, welche aus breitenmodulierten Impulsen gleicher Frequenz bestehen und die um den halben Abstand zwischen zwei aufeinanderfolgenden Impulsen gegeneinander verschoben sind, was im folgenden noch ausführlich beschrieben werden wird. Diese Impulsfolgen werden getrennt voneinander in zugeordneten Schaltstufen verstärkt und danach auf eine von der Speisespannung galvanisch getrennte gemeinsame Leitung gegeben. Die aus den beiden überlagerten Eingangsimpulsfolgen gebildete Ausgangsimpulsfolge wird dann in einem Tiefpaßfilter in ein leistungsverstärktes NF-Signal umgewandelt, das dem ursprünglichen NF-Signal entspricht.

Beim Aufbau des neuen NF-Leistungsverstärkers ist davon auszugehen, daß die Einschaltfrequenz der üblichen Schaltelemente begrenzt und das Tastverhältnis wegen der Ummagnetisierung der Leistungsübertrager auf etwa 1 : 1 oder 50% Aussteuerung beschränkt ist.

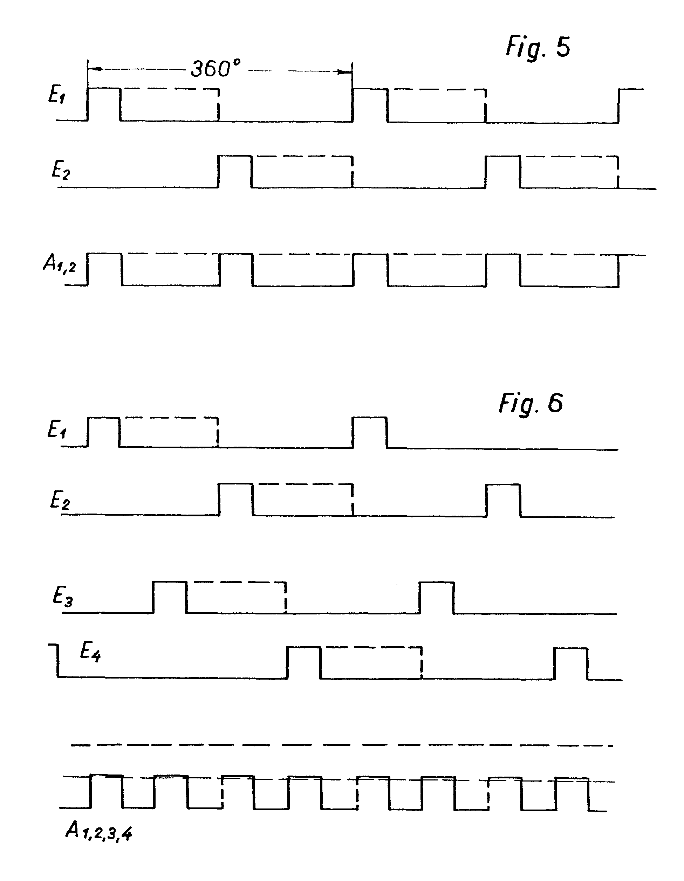

Um das Tastverhältnis bzw. die Aussteuerung der Ausgangsimpulsfolge zu verbessern, werden zwei um 180° phasenverschobene Eingangsimpulsfolgen verwendet, wie es schematisch in Fig. 5 gezeigt ist. Die beiden Eingangsimpulsfolgen $E_1$ und $E_2$ weisen gleiche Impulsfolgefrequenz und eine Phasenverschiebung von 180° auf. Die mit durchgezogenen Linien gezeigte Impulsbreite entspricht einer Aussteuerung von 12,5%, die gestrichelt gezeigte Impulsbreite eine Aussteuerung von 50% pro Eingangsimpulsfolge. Wie die Figur zeigt, ergibt die Überlagerung dieser beiden Eingangsimpulsfolgen eine Ausgangsimpulsfolge $A_{1,\,2}$, die praktisch zu 100% ausgesteuert ist, wenn die beiden Eingangsimpulsfolgen zu 50% ausgesteuert sind.

Zum Erzeugen der beschriebenen Eingangsimpulsfolgen wird der in Fig. 2 gezeigte Impulsmofulator verwendet. Der Impulsgenerator 20 erzeugt eine Folge von Dreieckimpulsen, deren Frequenz tiefer als die höchste Schaltfrequenz der Schaltelemente liegt. Diese Impulse werden im Modulator 21 mit dem an der Eingangsklemme 24 liegenden NF-Signal überlagert, wobei breitenmodulierte Impulse entstehen, die auf die Signalleitung 26 gegeben werden. Die vom Impulsgenerator erzeugten Dreieckimpulse werden auch an den Phasenschieber 22 geleitet, der die Impulse um 180° oder den halben zeitlichen Abstand zwischen zwei Impulsen verschiebt. Diese phasenverschobene Impulsfolge wird dann im nachgeschalteten Modulator 23 ebenfalls mit dem NF-Signal überlagert, um breitenmodulierte Impulse zu bilden, die dann auf der Signalleitung 27 erscheinen.

Es versteht sich, daß auch andere Arten der Impulsmodulation verwendet werden können und der Impulsmodulator nicht notwendigerweise wie in Fig. 2 gezeigt aufgebaut sein muß. Beispielsweise ist es auch möglich, einen Impulsgenerator zu verwenden, der sägezahnförmige Impulse oder einfach eine Folge von Taktimpulsen erzeugt, bei deren Erscheinen das NF-Signal abgetastet wird. In einer zugeordneten Logikschaltung werden die der Amplitude des NF-Signals entsprechenden breitenmodulierten Impulse gebildet. Solche Verfahren und Einrichtungen sind jedem Fachmann bekannt, weshalb sie hier nicht weiter diskutiert werden.

Wie bereits erwähnt, ist die Frequenz der Eingangsimpulsfolge auf jeder der Signalleitungen durch die maximale Einschaltfrequenz der Schaltelemente begrenzt. Das ergibt bei den beschriebenen zwei um 180° phasenverschobenen Eingangsimpulsfolgen eine Ausgangsimpulsfolge mit der doppelten Frequenz. Um Ausgangsimpulsfolgen mit einer höheren und beispielsweise der doppelten Frequenz zu erzeugen, können zwei Paare der oben beschriebenen Eingangsimpulsfolgen, welche symmetrisch gegeneinander phasenverschoben sind, verwendet werden, wie es in Fig. 6 schematisch gezeigt ist. Im oberen Teil der Fig. 6 sind die bereits beschriebenen, um 180° phasenverschobenen Eingangsimpulsfolgen $E_1$ und $E_2$ gezeigt, im mittleren Teil ein zweites Impulsfolgepaar $E_3$ und $E_4$. Diese beiden Impulsfolgen sind gegeneinander ebenfalls um 180° und gegen die entsprechenden Impulsfolgen des ersten Impulsfolgepaars, d. h. $E_3$ gegen $E_1$ und $E_4$ gegen $E_2$ um 90° phasenverschoben. Die Überlagerung dieser vier Eingangsimpulsfolgen ergibt dann eine Ausgangsimpulsfolge $A_{1,\,2,\,3,\,4}$ mit der vierfachen Frequenz der einfachen Eingangsimpulsfolge bzw. bei 50% Aussteuerung eine Ausgangsimpulsfolge, die aus zwei überlagerten, zu praktisch 100% ausgesteuerten Impulsfolgen besteht.

Zum Erzeugen dieser Eingangsimpulsfolgen enthält der in Fig. 2 gezeigte Impulsmodulator zwei zusätzliche Phasenschieber mit nachgeschalteten Modulatoren, was durch die gestrichelten Linien angedeutet ist.

Es versteht sich, daß die Frequenz der Ausgangsimpulsfolge weiter erhöht werden kann, wenn beispielsweise vier zusätzliche Eingangsimpulsfolgen gebildet werden, die gegenüber den bereits beschriebenen Eingangsimpulsfolgen um 45° phasenverschoben sind, usw.

Jeder Impulsfolge ist mindestens eine Schaltstufe zugeordnet. Die eingehenden Impulse schalten die Schaltelemente, so daß die Primärwicklung des Übertragers in Übereinstimmung mit der Impulsbreite erregt wird und an den Ausgangsleitungen eine von der Speisespannung galvanisch getrennte, leistungsverstärkte Impulsfolge erscheint. Wie bereits erwähnt wurde, können zur Erhöhung der Leistungsverstärkung in jeder Schaltstufe mehrere Schaltelemente parallel geschaltet werden, und es können auch mehrere Schaltstufen parallel geschaltet werden. Das Übersetzungsverhältnis der Übertragerwicklungen wird entsprechend der für die leistungsverstärkten Impuls angestrebten Spannung gewählt.

Der neue NF-Leistungsverstärker ermöglicht, mit der beschriebenen Modulation paarweise zugeordneter, um 180° phasenverschobener Eingangsimpulsfolgen die Ausgangsimpulsfolge praktisch zu 100% auszusteuern und durch die Verwendung mehrerer solcher Eingangsimpulsfolgenpaare die Frequenz der Ausgangsimpulsfolge auf ein Mehrfaches der Frequenz jeder Eingangsimpulsfolge zu erhöhen.

Bei einer praktisch erprobten Ausführungsform wird der neue NF-Leistungsverstärker zum Speisen eines amplitudenmodulierten Rundfunksenders mit Niederfrequenz im üblichen Tonfrequenzbereich mit einer Spitzenleistung von mehr als 1 MW verwendet. Für eine ausreichende Übertragungsqualität wird in diesem Fall das NF-Eingangssignal, wie es in Fig. 6 gezeigt ist, auf zwei Paare gegenseitig phasenverschobener Eingangsimpulsfolgen moduliert.

Bezeichnungsliste

| | |
|---|---|
| 10 | Impulsmodulator |
| 11—14 | Schaltstufen |
| 15 | Verbindungsleitung |
| 17 | Tiefpaßfilter |
| 18 | Last |

| 20 | Impulsgenerator |
|----|-----------------|
| 21 | Modulator |
| 22 | Phasenschieber |
| 23 | Modulator |
| 24 | Eingangsklemme |
| 26, 27 | Signalleitungen |
| 30, 31 | Signaleingang |
| 32 | Primärwicklung |
| 33 | Steuer-Einheit |
| 34, 35 | Sekundärteil der Steuer-Einheit |
| 36, 37 | Schaltelemente |
| 38 | positive Schiene |
| 39 | negative Schiene |
| 41 | Primärwicklung |
| 42 | Leistungsübertrager |
| 43 | Sekundärwicklung |
| 44, 45 | Ausgangsleitungen |
| 46, 47 | Dioden |
| 50, 51 | Gleichrichter |
| 53 | Eingang Tiefpaßfilter |

## Patentansprüche

1. NF-Leistungsverstärker mit einem Impulsmodulator (10), der ein NF-Eingangssignal in mindestens zwei phasenverschobene Impulsfolgen ($E_1$, $E_2$) gleicher Frequenz und mit breitenmodulierten Impulsen umwandelt, und mindestens zwei von den Impulsfolgen gesteuerten Schaltstufen (11, 13), deren Speisespannungseingänge (38, 39) parallel geschaltet sind, sowie einem den Schaltstufen nachgeschalteten Tiefpaßfilter (17), an dessen Ausgang das leistungsverstärkte NF-Signal erscheint, dadurch gekennzeichnet, daß die Phasenverschiebung zwischen den Impulsfolgen ($E_1$, $E_2$) 180° beträgt, die Ausgänge (44, 45) der Schaltstufen (11, 13) galvanisch von den Speisespannungseingängen (38, 39) getrennt und zur Aufsummierung der Ausgangsspannung in Serie geschaltet sind.

2. NF-Leistungsverstärker nach Anspruch 1, dadurch gekennzeichnet, daß der Impulsmodulator (10) zum Umwandeln des NF-Eingangssignals in eine Mehrzahl Impulsfolgenpaare ($E_1$, $E_2$; $E_3$, $E_4$; usw.) vorgesehen ist, wobei die Impulsfolgen jedes Paars um 180° gegeneinander verschoben sind und die Impulsfolgenpaare um 90° bzw. 60° bzw. 45° usw. gegenüber dem ersten Impulsfolgenpaar verschoben sind.

3. NF-Leistungsverstärker nach Anspruch 1, dadurch gekennzeichnet, daß jede Schaltstufe einen Übertrager (42) enthält, dessen Primärwicklung (41) über mindestens ein Schaltelement (36) mit der Speisespannungsleitung (38, 39) und dessen Sekundärwicklung (43) mit den Ausgangsleitungen (44, 45) verbunden ist, sowie eine Steuereinheit (33) enthält, deren Primärteil für die Übertragung des Ein- bzw. Ausschaltsignals mit dem entsprechenden Ausgang (26) des Impulsmodulators (Fig. 2) und deren mindestens ein Ausgang (34) mit der Steuerelektrode des mindestens einen Schaltemrentes verbunden ist.

4. NF-Leistungsverstärker nach Anspruch 3, dadurch gekennzeichnet, daß die Primärwicklung (41) des Übertragers (42) beidseitig über ein Schaltelement (36, 37) mit den Speisespannungseingängen (38, 39) verbunden ist und die Steuereinheit (33) zwei Sekundärteile (34, 35) aufweist, von denen jeder auf die Steuerelektrode eines der beiden Schaltelemente einwirkt.

5. NF-Leistungsverstärker nach Anspruch 3, dadurch gekennzeichnet, daß als Schaltelemente (36, 37) Leistungshalbleiter, Elektronenröhren oder eine geeignete Kombination derselben verwendet werden.

6. NF-Leistungsverstärker nach Anspruch 1, dadurch gekennzeichnet, daß die Verbindungsleitung (15) zur Bildung einer Kaskadenschaltung zwischen den Anschlüssen der Ausgangsleitungen (44, 45) jeder Schaltstufe (11) einen ersten Gleichrichter (51) aufweist und in der einen Ausgangsleitung (45) jeder Stufe ein zweiter Gleichrichter (50) vorgesehen ist.

7. NF-Verstärker nach Anspruch 1, dadurch gekennzeichnet, daß das Tiefpaßfilter (17) an das Ende der Verbindungsleitung (15) gelegt wird.

8. NF-Leistungsverstärker nach Anspruch 1, dadurch gekennzeichnet, daß das Tiefpaßfilter ganz oder teilweise in die Ausgänge (44, 45) der Leistungsschaltelemente (11, 12, . . .) bzw. in die Verbindungsleitung (15) integriert wird.

9. NF-Leistungsverstärker nach Anspruch 1, dadurch gekennzeichnet, daß zum Aufrechterhalten der Funktion des Verstärkers auch beim Ausfall einzelner Schaltstufen jeder der mindestens zwei Schaltstufen (11, 13) weitere Schaltstufen parallel geschaltet sind.

10. Verwendung des NF-Leistungsverstärkers gemäß Anspruch 1, zum Erzeugen der durch die NF modulierten Anodengleichspannung für die Hochfrequenz-Leistungsstufe eines amplitudenmodulierten Senders.

## Claims

1. Low-frequency power amplifier having a pulse modulator (10) which converts a low-frequency input signal into at least two phase-shifted pulse sequences ($E_1$, $E_2$) with identical frequency and containing width-modulated pulses, and at least two switching stages (11, 13) which are controlled by the pulse sequences and the supply-voltage inputs (38, 39) of which are connected in parallel, and a low-pass filter (17) which follows the switching stages in the circuit and at the output of which the power-amplified low-frequency signal appears, characterised in that the phase shift between the pulse sequences ($E_1$, $E_2$) is 180°, and the outputs (44, 45) of the switching stages (11, 13) are electrically isolated from the supply-voltage inputs (38, 39) and are connected in series for the purpose of summing the output voltage.

2. Low-frequency power amplifier according to claim 1, characterised in that the pulse modulator (10) is intended for converting the low-frequency input signal into a plurality of pairs of

pulse sequences ($E_1$, $E_2$; $E_3$, $E_4$; and so forth), the pulse sequences of each pair being displaced by 180° with respect to one another and the pulse sequence pairs being displaced by 90° or 60° or 45° and so forth with respect to the first pulse sequence pair.

3. Low-frequency power amplifier according to claim 1, characterised in that each switching stage contains a transformer (42) the primary winding (41) of which is connected via at least one switching element (36) to the suply-voltage line (38, 39) and the secondary winding (43) of which is connected to the output lines (44, 45), and a control unit (33) the primary section of which is connected, for the purpose of transferring the switching-on or switching-off signal, to the corresponding output (26) of the pulse modulator (figure 2) and the at least one output (34) of which is connected to the control electrode of the at least one switching element.

4. Low-frequency power amplifier according to claim 3, characterised in that the primary winding (41) of the transformer (42) is connected on both sides via a switching element (36, 37) to the supply-voltage inputs (38, 39) and the control unit (33) has two secondary sections (34, 35) each of which acts on the control electrode of one of the two switching elements.

5. Low-frequency power amplifier according to claim 3, characterised in that power semiconductors, electron valves or a suitable combination of these are used as the switching elements (36, 37).

6. Low-frequency power amplifier according to claim 1, characterised in that the connecting line (15) for forming a cascade circuit has a first rectifier (51) between the connections of the output lines (44, 45) of each switching stage (11) and a second rectifier (50) is provided in the one output line (45) of each stage.

7. Low-frequency power amplifier according to claim 1, characterised in that the low-pass filter (17) is connected to the end of the connecting line (15).

8. Low-frequency power amplifier according to claim 1, characterised in that the low-pass filter is wholly or partially integrated into the outputs (44, 45) of the power switching elements (11, 12, . . .) or into the connecting line (15).

9. Low-frequency power amplifier according to claim 1, characterised in that for the purpose of maintaining the amplifier function, each of the at least two switching stages (11, 13) is connected in parallel with further switching stages even if individual switching stages fail.

10. Use of the low-frequency power amplifier according to claim 1, for generating the low-frequency-modulated anode direct-voltage for the high-frequency power stage of an amplitude-modulated transmitter.

## Revendications

1. Amplificateur de puissance BF comportant un modulateur d'impulsions (10) qui convertit un signal d'entrée BF en au moins deux séquences d'impulsions déphasées ($E_1$, $E_2$) de même fréquence et dont les impulsions sont modulées en durée, et au moins deux étages de commutation (11, 13) commandés par les séquences d'impulsions, dont les entrées de tension d'alimentation (38, 39) sont connectées en parallèle, ainsi qu'un filtre passe-bas (17) connecté en aval des étages de commutation, à la sortie duquel apparaît le signal BF amplifié en puissance, caractérisé en ce que le déphasage entre les séquences d'impulsions ($E_1$, $E_2$) est de 180°, les sorties (44, 45) des étages de commutation (11, 13) étant séparées galvaniquement des entrées de tension d'alimentation (38, 39) et étant connectées en série en vue de la sommation de la tension de sortie.

2. Amplificateur de puissance BF suivant la revendication 1, caractérisé en ce que le modulateur d'impulsions (10) est prévu pour convertir le signal d'entrée BF en pulsieurs paires de séquences d'impulsions ($E_1$, $E_2$; $E_3$, $E_4$; etc.), les séquences d'impulsions de chaque paire étant déphasées de 180° l'une par rapport à l'autre et les paires de séquences d'impulsions étant déphasées de 90, de 60 ou de 45°, etc. par rapport à la première paire de séquences d'impulsions.

3. Amplificateur de puissance BF suivant la revendication 1, caractérisé en ce que chaque étage de commutation comporte un transformateur (42) dont le primaire (41) est connecté par l'intermédiaire d'au moins un élément de commutation (36) à la ligne de tension d'alimentation (38, 39) et dont le secondaire (43) est connecté aux lignes de sortie (44, 45), ainsi qu'une unité de commande (33) dont la partie primaire est connectée à la sortie correspondante (26) du modulateur d'impulsions (Fig. 2) pour la transmission du signal d'enclenchement ou de déclenchement et dont au moins une sortie (34) est connectée à l'électrode de commande d'au moins un élément de commutation.

4. Amplificateur de puissance BF suivant la revendication 3, caractérisé en ce que le primaire (41) du transformateur (42) est connecté des deux côtés par l'intermédiaire d'un élément de commutation (36, 36) aux entrées de tension d'alimentation et l'unité de commande (33) présente deux parties secondaires (34, 35) qui agissent chacune sur l'électrode de commande d'un des deux éléments de commutation.

5. Amplificateur de puissance BF suivant la revendication 3, caractérisé en ce qu'à titre d'éléments de commutation (36, 37) on utilise des semiconducteurs de puissance, des tubes électroniques ou une combinaison adéquate de ceux-ci.

6. Amplificateur de puissance BF suivant la revendication 1, caractérisé en ce que la ligne de liaison (15) présente, pour former un montage en cascade entre les connexions des lignes de sortie (44, 45) de chaque étage de commutation (11), un premier redresseur (51), un deuxième redresseur (50) étant prévu dans la première ligne de sortie (35) de chaque étage.

7. Amplificateur de puissance BF suivant la revendication 1, caractérisé en ce que le filtre passebas (17) est connecté à l'extrémité de la ligne de liaison (15).

8. Amplificateur de puissance BF suivant la revendication 1, caractérisé en ce que le filtre passebas est intégré complétement ou partiellement dans les sorties (44, 45) des éléments de commutation de puissance (11, 12, . . .) ou dans la ligne de liaison (15).

9. Amplificateur de puissance BF suivant la revendication 1, caractérisé en ce que pour maintenir l'amplificateur en fonctionnement, même en cas de défaillance de certains étages de commutation, d'autres étages de commutation sont connectés en parallèle à chacun des étages de commutation (11, 13) prévus au nombre d'au moins deux.

10. Utilisation de l'amplificateur de puissance BF suivant la revendication 1 pour produire la tension continue d'anode modulée par la basse-fréquence pour l'étage de puissance à haute fréquence d'un émetteur à modulation d'amplitude.

Fig. 1

Fig. 2

Fig. 3

Fig. 4

*Fig. 5*

*Fig. 6*